# EUROPÄISCHE PATENTANMELDUNG

(11) **EP 4 738 706 A2**
(43) Veröffentlichungstag der Anmeldung: **06.05.2026**
(21) Anmeldenummer: 25204021.7
(22) Anmeldetag: 23.09.2025
(51) Int. Cl.: H03K 17/968

(54) **BEDIENELEMENT FÜR EIN HAUSHALTSGERÄT**

(30) Priorität: 10.10.2024 DE 102024209873
(71) Anmelder: BSH Hausgeräte GmbH, 81739 München (DE)
(72) Erfinder: Schemmerer, Roman, 84088 Neufahrn i. NB (DE); Mayer, Stefan, 92269 Fensterbach (DE)

(57) **Zusammenfassung**

Ein Bedienelement (110) für ein Haushaltsgerät (100) umfasst eine Lichtquelle (130) und einen Lichtsensor (135); und eine transparente Scheibe (120) zur Abdeckung der Lichtquelle (130) und des Lichtsensors (135). Die Scheibe (120) ist in Abhängigkeit einer auf sie wirkenden Betätigungskraft elastisch verformbar; und die Scheibe (120), die Lichtquelle (130) und der Lichtsensor (135) sind derart zueinander angebracht, dass ein erster Teil (140) eines durch die Lichtquelle (130) bereitgestellten Lichtstroms durch die Scheibe (120) fällt und ein zweiter Teil (145) des Lichtstroms an der Scheibe (120) in Richtung des Lichtsensors (135) reflektiert wird. Ferner ist eine Verarbeitungseinrichtung (165) zur Bestimmung der Betätigungskraft auf der Basis eines vom Lichtsensor (135) erfassten Lichtstroms vorgesehen.

## Beschreibung

Die vorliegende Erfindung betrifft ein Bedienelement für ein Haushaltsgerät. Insbesondere betrifft die Erfindung ein haptisches Bedienelement mit Kraftbestimmung.

Ein Haushaltsgerät umfasst ein Bedienelement, um eine vorbestimmte Funktion des Haushaltsgeräts zu steuern. Das Haushaltsgerät kann beispielsweise einen Geschirrspüler umfassen, und das Bedienelement kann dazu verwendet werden, eines von mehreren möglichen Spülprogrammen auszuwählen.

In manchen Fällen ist es wünschenswert, eine Funktion in Abhängigkeit einer Betätigungskraft des Bedienelements zu steuern. Dazu kann das Bedienelement eine flexible Scheibe aufweisen, die beispielsweise mittels eines Fingers einer Bedienperson betätigt werden kann. Die Betätigung kann insbesondere mit einer Betätigungskraft erfolgen, die senkrecht auf die Scheibe wirkt. Eine Deformation der Scheibe kann mittels eines integrierten optischen Sensors bestimmt werden, der auf einer vom Benutzer abgewandten Seite der Scheibe angebracht ist.

Um den Benutzer verbessert darüber zu orientieren, welche Funktion durch Betätigen der Scheibe verfügbar ist, kann die Scheibe mit einem entsprechenden Symbol versehen werden, das auf die Funktion hinweist. Die Scheibe kann im Bereich des Symbols mittels einer Beleuchtungseinrichtung beleuchtet werden, um auch eine Bedienung in dunkler Umgebung zu erlauben.

Ein solches Bedienelement ist komplex aufgebaut. Der Deformationssensor und die Beleuchtungseinrichtung können denselben Bauraum beanspruchen, sodass eine Integration schwierig sein kann.

Eine der vorliegenden Erfindung zu Grunde liegende Aufgabe besteht in der Bereitstellung eines verbesserten Bedienelements, insbesondere für ein Haushaltsgerät. Die Erfindung löst diese Aufgabe mittels der Gegenstände der unabhängigen Ansprüche. Unteransprüche geben bevorzugte Ausführungsformen wieder.

Nach einem ersten Aspekt der vorliegenden Erfindung umfasst ein Bedienelement für ein Haushaltsgerät eine Lichtquelle und einen Lichtsensor sowie eine transparente Scheibe zur Abdeckung der Lichtquelle und des Lichtsensors. Die Scheibe ist in Abhängigkeit einer auf sie wirkenden Betätigungskraft elastisch verformbar; und die Scheibe, die Lichtquelle und der Lichtsensor sind derart zueinander angebracht, dass ein erster Teil eines durch die Lichtquelle bereitgestellten Lichtstroms durch die Scheibe fällt und ein zweiter Teil des Lichtstroms an der Scheibe in Richtung des Lichtsensors reflektiert wird. Ferner ist eine Verarbeitungseinrichtung zur Bestimmung der Betätigungskraft auf der Basis eines vom Lichtsensor erfassten Lichtstroms vorgesehen.

Vorteilhaft können ein optischer Sensor zur Bestimmung einer Verformung der Scheibe und eine Beleuchtung der Scheibe mittels einer gemeinsamen Lichtquelle erfolgen. Das Bedienelement kann dadurch verbessert kompakt aufgebaut sein. Die Lichtquelle kann verbessert so positioniert sein, dass die Scheibe homogen ausgeleuchtet wird. Optional sind mehrere Lichtquellen vorgesehen, die bevorzugt in gleichem Abstand zur Scheibe derart angeordnet sind, dass ein vorbestimmter Abschnitt der Scheibe gleichmäßig ausgeleuchtet wird. Ein auf den Lichtsensor fallender Lichtstrom kann von einer oder mehreren der Lichtquellen ausgehen. Das Bedienelement kann flexibel eingesetzt werden, um eine vorbestimmte Betätigungscharakteristik und eine vorbestimmte Beleuchtungscharakteristik miteinander zu verbinden. Die Lichtquelle und der Lichtsensor können diskrete Bauteile umfassen, die mit vergrößerter Flexibilität eingesetzt werden können. Bevorzugt sind Lichtsensor und eine Lichtquelle jeweils als oberflächenmontiertes Bauteil (Surface-Mounted Device, SMD) ausgeführt und auf einer gemeinsamen Leiterplatte angebracht. Die Leiterplatte kann auf einer Seite der Scheibe liegen, während ein Benutzer die andere Seite der Scheibe betätigen kann.

Die Verarbeitungseinrichtung ist bevorzugt dazu eingerichtet, eine vorbestimmte Funktion des Haushaltsgeräts in Abhängigkeit der bestimmten Betätigungskraft zu steuern. In einer Ausführungsform kann die Funktion nur dann gesteuert werden, wenn die Betätigungskraft einen vorbestimmten Schwellenwert übersteigt. In einer weiteren Ausführungsform sind mehrere, unterschiedlich große Schwellenwerte vorgesehen, wobei unterschiedliche Funktionen jeweils in Abhängigkeit des Überschreitens eines zugeordneten Schwellenwerts durch die Betätigungskraft gesteuert werden können. Ein Abschnitt der Scheibe kann dadurch zur Steuerung unterschiedlicher Funktionen genutzt werden, eine Anzahl von Funktionen, die auf einer vorbestimmten Fläche der Scheibe gesteuert werden kann, kann dadurch erhöht sein. Anders ausgedrückt kann eine Funktionsdichte von steuerbaren Funktionen am Haushaltsgerät durch eine Doppel- oder Mehrfachbelegung erhöht sein. In einer anderen Ausführungsform kann eine Funktion in Abhängigkeit einer Betätigungsstärke parametriert werden. Beispielsweise kann ein Kochfeld mittels des Bedienelements gesteuert werden, wobei eine bereitgestellte Wärmeleistung abhängig von der Größe der Betätigungskraft ist.

In noch einer weiteren Ausführungsform kann das Bedienelement dazu verwendet werden, eine Kindersicherung zu realisieren. Dabei ist die Verarbeitungseinrichtung dazu eingerichtet, zu bestimmen, dass die Betätigungskraft einen vorbestimmten Schwellenwert übersteigt; und in diesem Fall ein weiteres Bedienelement des Haushaltsgeräts in Abhängigkeit der Betätigung zu aktivieren.

Das weitere Bedienelement kann erst aktiviert werden, wenn das vorliegende Bedienelement mit einer Kraft betätigt wurde, deren Aufbringen von einem Kleinkind nicht zu erwarten ist. Optional kann die Aktvierung des weiteren Bedienelements erst erfolgen, wenn die Betätigung des vorliegenden Bedienelements mit der vorbestimmten Kraft über eine vorbestimmte Zeit aufrechterhalten wird. Ein potenziell gefährliches Haushaltsgerät wie ein Bügeleisen oder ein Herd können dadurch verbessert gegen die Bedienung durch ein Kleinkind gesichert werden.

Bevorzugt umfasst die Scheibe eine Maske, um dem ersten Lichtstrom ein vorbestimmtes Muster aufzuprägen. Das Muster kann einen Hinweis auf eine durch Betätigen des Bedienelements steuerbare Funktion umfassen. In einer Ausführungsform umfasst das Muster ein Symbol. Das Symbol kann monochrom sein und lediglich abgedeckte und nicht abgedeckte Abschnitte umfassen. In einer weiteren Ausführungsform umfasst das Muster unterschiedlich transparente Abschnitte. Dadurch sind unterschiedliche Helligkeitsstufen an den Abschnitten steuerbar. Beispielsweise kann so ein Helligkeitsverlauf auf einer Fläche dargestellt werden. Das Muster kann nach Art eines Graustufenbilds dargestellt werden, wobei der erste Lichtstrom nicht notwendigerweise weißes Licht umfassen muss, sondern Licht in einer beliebigen Farbe aufweisen kann. In noch einer weiteren Ausführungsform umfasst das Muster unterschiedlich gefärbte Abschnitte. Die Abschnitte können gerastert, und es können mehrere Grundfarben vorgesehen sein, die in Rasterelementen jeweils proportional verteilt werden können. Das Muster kann auf diese Weise in mehreren Farben dargestellt werden. Ist das Raster ausreichend klein gewählt, so kann eine fotorealistische Darstellung erreicht werden. Beispielsweise kann das Bedienelement dazu eingesetzt werden, ein Betriebsprogramm eines Backofens so einzustellen, dass damit Pizza gebacken werden kann, und das Muster kann eine Abbildung einer Pizza darstellen.

Die Scheibe kann mehrere Schichten umfassen bzw. aus mehreren Schichten aufgebaut sein. Jede Schicht kann insbesondere einen Film, eine Folie oder eine Scheibe umfassen. So können beispielsweise eine Schutzschicht, eine Diffusionsschicht, eine Polarisationsschicht, ein Dunkelfilter, eine Klebstoffschicht und/oder eine Elektrodenschicht in geeigneter Weise aufeinandergestapelt sein. Eine der Schichten kann die Maske tragen. Zwischen Schichten der Scheibe kann eine Luftschicht vorgesehen sein.

Mechanische und insbesondere elastische Eigenschaften der Scheibe können durch eine der von ihr umfassten Schichten beeinflusst sein. So kann der Grad der Verformung der Scheibe in Abhängigkeit einer Betätigung mit einer vorbestimmten Betätigungskraft in Abhängigkeit der Dicke und/oder des Materials einer der Schichten gesteuert werden. In einer Ausführungsform ist eine Diffusionsschicht vorgesehen, die dazu eingerichtet ist, einen durchtretenden Lichtstrom zu homogenisieren. In einer Ausführungsform ist diese Schicht in ihrer Dicke so gewählt, dass sich vorbestimmte elastische Eigenschaften der Scheibe einstellen. In anderen Ausführungsformen können auch eine oder mehrere der anderen Schichten entsprechend variiert werden.

In einer weiteren Ausführungsform ist ein opaker (intransparenter) Abschnitt der Maske dazu eingerichtet, einen von der Lichtquelle aus einstrahlenden Lichtstrom zu reflektieren. Die Maske kann also gleichzeitig dazu verwendet werden, das Durchtreten des Lichtstroms zu verhindern und den Lichtstrom von der Lichtquelle zum Lichtsensor zu reflektieren. Im Fall einer teilweisen Durchlässigkeit des Abschnitts der Maske kann dementsprechend auch ein teilweises Reflektieren des Lichtstroms erfolgen.

Optional ist ein Reflexelement vorgesehen, das an der Scheibe angebracht ist, um einen Teil des von der Lichtquelle einfallenden Lichtstroms zu reflektieren. Das Reflexelement kann eine relativ geringe horizontale Ausdehnung aufweisen und an einem Abschnitt der Scheibe angebracht sein, an dem der Lichtstrom der Lichtquelle in Abhängigkeit der Verformung der Scheibe in Richtung des Lichtsensors reflektiert wird. Durch passende Anordnung der Lichtquelle sowie optional weiterer Lichtquellen und weiter optional durch Einsatz einer entsprechenden Diffusionsschicht kann weitgehend verhindert werden, dass das Reflexelement einen unerwünschten dunklen Schatten für einen Betrachter der Scheibe bewirkt.

Die Scheibe kann eine Elektrode umfassen; wobei die Verarbeitungseinrichtung dazu eingerichtet ist, eine Berührung der Scheibe auf der Basis einer Änderung der Kapazität der Elektrode zu bestimmen. So kann ein kapazitiver Berührungs- oder Näherungsschalter gebildet sein, der mit dem kraftsensitiven Bedienelement integriert ausgeführt ist. Beispielsweise kann das Bedienelement eine Bedienung bzw. Berührung auch dann feststellen, wenn eine Verformung der Scheibe nicht stattfindet oder zu gering ist, um mittels der beschriebenen optischen Anordnung erfasst zu werden. Weiter bevorzugt ist die Verarbeitungseinrichtung dazu eingerichtet, eine Funktion des Haushaltsgeräts in Abhängigkeit der Berührung zu steuern. Die Elektrode kann beispielsweise eine Anordnung feiner Leiterstrecken (Mesh), eine aufgedampfte Leiterschicht oder eine leitfähige Schicht umfassen.

In einer weiteren Ausführungsform wird ein Ort bzw. eine Stelle, an der die Scheibe berührt wird, beispielsweise auf kapazitive Weise bestimmt, insbesondere mittels der Elektrode, und nur eine Kraft, mit der die Scheibe betätigt wird, mittels eines hierin beschriebenen optischen Sensors, also mittels der Lichtquelle und des Lichtsensors. Vorteilhaft können mittels nur eines einzigen optischen Sensors Betätigungskräfte an verschiedenen Stellen der Scheibe bestimmt werden. Für die Bestimmung der Betätigungskraft kann berücksichtigt werden, in welcher Lage eine betätigte Stelle zum Sensor liegt. Insbesondere können Hebelkräfte zwischen der betätigten Stelle und der reflektierenden Stelle berücksichtigt werden. Die Bestimmung der Kraft kann dann entsprechend kompensiert werden, sodass korrekte Kräfte an verschiedenen Stellen bestimmt werden können. So können mehrere kraftsensitive und hinterleuchtete Bedienelemente an der Scheibe mittels nur eines optischen und eines kapazitiven Sensors abgetastet werden.

Das Bedienelement kann ein Stützelement aufweisen, um eine Verformung der Scheibe auf einen Abschnitt zu begrenzen, in welchem die Lichtquelle und der Lichtsensor angeordnet sind. Elastische Eigenschaften der Scheibe im Bereich der Lichtquelle und des Lichtsensors können so besser gesteuert werden. Außerdem kann die Scheibe mehrere Abschnitte aufweisen, die unabhängig voneinander betätigt werden können, wobei Betätigungskräfte in den einzelnen Abschnitten getrennt voneinander bestimmt werden können.

In einer besonders bevorzugten Ausführungsform umfasst die Scheibe mehrere Abschnitte, wobei den Abschnitten voneinander unabhängige Einrichtungen zur Erfassung einer Betätigung und/oder Berührung eines Abschnitts zugeordnet sind. Ein Abschnitt kann einen hierin beschriebenen kapazitiven Sensor und/oder eine hierin beschriebene optische Erfassungseinrichtung zur Bestimmung einer Betätigungskraft der Scheibe umfassen. Unterschiedliche Abschnitte können unterschiedlich abgetastet werden. So kann auch eine komplexe Bedienoberfläche für das Haushaltsgerät leicht ausgebildet werden. Beispielsweise kann ein Bedienelement, das eine Bedienperson mittels ihres Fingers verschieben kann (Slider), rein kapazitiv ausgeführt sein, während ein anderes Bedienelement zusätzlich oder ausschließlich zur Bestimmung einer Betätigungskraft eingerichtet sein kann.

Das Bedienelement kann einen Aktuator umfassen, der mit der Scheibe verbunden ist. Die Verarbeitungseinrichtung ist dann dazu eingerichtet, den Aktuator in Abhängigkeit einer erfassten Betätigung anzusteuern. So kann eine haptische Rückmeldung über die Betätigung des Bedienelements ausgegeben werden. Der Aktuator kann beispielsweise einen Impulsgeber oder ein Vibrationselement umfassen. In einer weiteren Ausführungsform kann auch eine optische Rückmeldung über die Betätigung des Bedienelements bereitgestellt werden, indem eine Stärke des Lichtstroms der Lichtquelle vorübergehend verändert wird.

Nach einem weiteren Aspekt der vorliegenden Erfindung umfasst eine Steuereinrichtung für ein Haushaltsgerät ein hierin beschriebenes Bedienelement. Bevorzugt umfasst die Steuereinrichtung mehrere Bedienelemente, die unterschiedliche Abschnitte einer gemeinsamen Scheibe verwenden können. Die Verarbeitungseinrichtung kann dazu eingerichtet sein, eine Benutzereingabe zu bestimmen und an eine Einrichtung zur Steuerung des Haushaltsgeräts weiterzuleiten. In einer anderen Ausführungsform ist die Steuereinrichtung dazu eingerichtet, das Haushaltsgerät in Abhängigkeit einer erfassten Benutzereingabe zu steuern.

Nach noch einem weiteren Aspekt der vorliegenden Erfindung umfasst ein Haushaltsgerät ein hierin beschriebenes Bedienelement oder eine hierin beschriebene Steuereinrichtung.

Nicht beschränkende Ausführungsformen der Erfindung werden nun unter Bezug auf die beiliegenden Figuren genauer beschrieben, in denen:
- Figur 1: ein Haushaltsgerät;
- Figur 2: einen Lichtstrom an einem Lichtsensor;
- Figur 3: eine beispielhafte Anordnung von Schichten einer Scheibe eines Bedienelements; und
- Figur 4: eine beispielhafte Bedienoberfläche eines Haushaltsgeräts
darstellen.

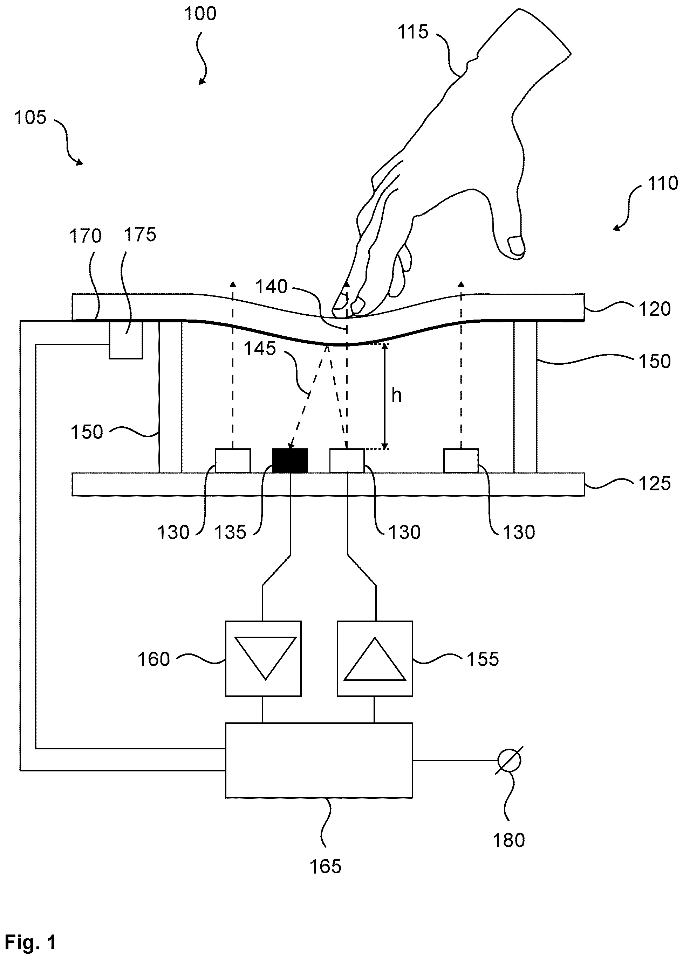

Figur 1 zeigt ein Haushaltsgerät 100 mit einer Steuereinrichtung 105. Die Steuereinrichtung 105 umfasst wenigstens ein Bedienelement 110, welches dazu eingerichtet ist, durch eine Person 115 betätigt zu werden. So kann die Steuereinrichtung 105 eine Benutzerschnittstelle des Haushaltsgeräts 100 bilden.

Das Bedienelement 110 umfasst eine transparente Scheibe 120 mit einer Oberseite und einer Unterseite. Die Oberseite ist der Person 115 zugewandt. In einem vorbestimmten Abstand von der Unterseite der Scheibe 120 ist eine Leiterplatte 125 angeordnet, die wenigstens eine Lichtquelle 130 sowie einen Lichtsensor 135 trägt. In der dargestellten, beispielhaften Ausführungsform sind mehrere Lichtquellen 130 vorgesehen, die derart an der Leiterplatte 125 verteilt sind, dass sie gemeinschaftlich einen vorbestimmten Lichtstrom bereitstellen.

Ein durch eine Lichtquelle 130 bereitgestellter Lichtstrom trifft von unten auf die Scheibe 120. Während ein erster Teil 140 des Lichtstroms durch die Scheibe 120 fällt, wird ein zweiter Teil 145 an ihrer Oberfläche reflektiert und trifft auf den Lichtsensor 135. Eine Stärke des mittels des Lichtsensors 135 erfassbaren Lichtstroms ist davon abhängig, wie stark die Scheibe 120 durch die Betätigung der Person 115 verformt wurde. Die Betätigung erfolgt mit einer Betätigungskraft, die bevorzugt im Wesentlichen senkrecht zu einer Oberfläche der Scheibe 120 wirkt. In der dargestellten Ausführungsform wird die Scheibe 120 durch die Betätigung lokal nach unten ausgelenkt und dabei verformt.

Um die Verformung auf einen vorbestimmten Abschnitt der Scheibe 120 zu begrenzen, können eines oder mehrere Stützelemente 150 vorgesehen sein. Ein Stützelement 150 kann zwischen der Scheibe 120 und einem Gehäuse oder Chassis des Haushaltsgeräts 100 wirken. In der vorliegenden Ausführungsform erfolgt die Abstützung beispielhaft gegenüber der Leiterplatte 125.

Eine Lichtquelle 130 kann mittels eines Treibers 155 angesteuert werden. Die Lichtquelle 130 ist bevorzugt als Leuchtdiode ausgeführt, wobei unterschiedliche Ausführungsformen bezüglich Größe, Montageart, Leuchtdichte, Wellenlängenbereich, Stromaufnahme etc. zur Verfügung stehen. Zur Verarbeitung eines Sensorsignals des Lichtsensors 135 kann ein Messverstärker 160 vorgesehen sein, der beispielsweise separat, als Teil des Lichtsensors 135 oder als Teil der Verarbeitungseinrichtung 165 ausgebildet sein kann. Optional umfasst der Messverstärker 160 einen Analog-Digital-Wandler.

Eine Verarbeitungseinrichtung 165 ist dazu eingerichtet, auf der Basis eines Sensorsignals des Lichtsensors 135 eine Betätigungskraft zu bestimmen, die auf die Scheibe 120 einwirkt. Die Bestimmung kann auf der Basis eines bekannten Elastizitätsmoduls der Scheibe 120 erfolgen, welches einen Zusammenhang zwischen einer Verformung und dem Betrag einer Betätigungskraft herstellt.

Optional ist die Verarbeitungseinrichtung 165 zusätzlich dazu eingerichtet, eine Annäherung der Person 115 an die Scheibe 120 auf kapazitivem Weg zu bestimmen. Dazu kann an der Scheibe 120 eine Elektrode 170 vorgesehen sein, die mit der Verarbeitungseinrichtung 165 verbunden ist. Wie unten noch genauer ausgeführt ist, kann die Elektrode 170 eine von mehreren Schichten der Scheibe 120 umfassen.

Die Verarbeitungseinrichtung 165 ist optional dazu eingerichtet, eine Rückmeldung über die Betätigung des Bedienelements 110 an die Person 115 auszugeben. Bei einer erfassten Betätigung kann eine optische Rückmeldung durch entsprechendes Ansteuern einer oder mehrerer der Lichtquellen 130 erfolgen. Darüber hinaus kann ein an der Scheibe 120 angebrachter Aktuator 175 angesteuert werden, um eine haptische Rückmeldung bereitzustellen. Der Aktuator 175 kann beispielsweise dazu eingerichtet sein, einen Impuls oder eine Vibration an die Scheibe 120 zu übertragen.

Über eine Schnittstelle 180 kann ein Signal oder eine Nachricht über die Betätigung der Scheibe 120 bereitgestellt werden. Das Haushaltsgerät 100 kann auf der Basis des Signals gesteuert werden, insbesondere indem eine vorbestimmte Funktion ausgeführt wird, die einer erfassten Betätigung zugeordnet ist. Wird das Haushaltsgerät 100 direkt durch die Steuereinrichtung 105 gesteuert, so kann das Signal insbesondere an einen Aktor des Haushaltsgeräts 100 geleitet werden.

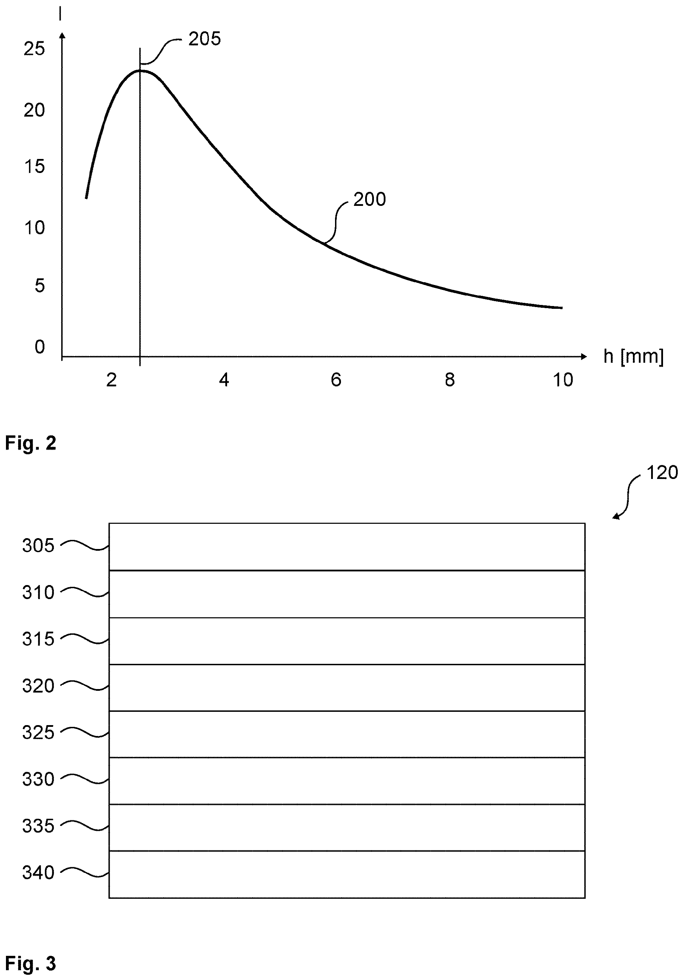

Figur 2 zeigt einen beispielhaften Zusammenhang 200 zwischen einem Lichtstrom l, der an einem Lichtsensor 135 eines Bedienelements 110 erfasst wurde, von einer Verformung der Scheibe 120. In einer vertikalen Richtung ist der Lichtstrom I und in einer horizontalen Richtung ein vertikaler Abstand zwischen der Scheibe 120 und dem Lichtsensor 135 bzw. der Lichtquelle 130 dargestellt. Dieser Abstand ist in Figur 1 angetragen und mit h bezeichnet.

An einem vorbestimmten Abstand 205 erreicht der Lichtstrom l sein Maximum. Ist der Abstand h geringer als der vorbestimmte Abstand 205, so erfolgt die Bestimmung der Deformation hauptsächlich auf der Basis einer Richtung, in die der zweite Teil 145 des Lichtstroms der Lichtquelle 130 reflektiert wird. Ist der Abstand h größer als der vorbestimmte Abstand 205, so überwiegt bei der Bestimmung der Verformung der absolute Einfluss des Abstands h.

Die Darstellung von Figur 2 geht von einer Lichtquelle 130 aus, die als Leuchtdiode (LED) ausgebildet ist und deren Leuchtstärke in Abhängigkeit der Leuchtrichtung keulenartig abnimmt.

Figur 3 zeigt eine Darstellung einer beispielhaften Scheibe 120, die aus unterschiedlichen Schichten zusammengesetzt ist.

In beispielhafter Weise umfasst die Scheibe 120 in der Darstellung von Figur 3 von oben nach unten eine Schutzschicht 305, einen Dunkelfilter 310, einen Farbfilter 315, eine Diffusionsschicht 320, eine Elektrodenschicht 325, eine Klebeschicht 330, eine Abblendschicht 335 und eine Lichtführungsschicht 340. Es ist zu beachten, dass in anderen Ausführungsformen einer Scheibe 120 auch andere Schichten 305 bis 340 vorgesehen sein können und dass eine Reihenfolge der Schichten 305 bis 340 variiert werden kann. Außerdem kann zwischen einzelnen Schichten 305 bis 340 jeweils eine Luftschicht bzw. ein Abstand vorgesehen sein.

Die Schutzschicht 305 ist dazu eingerichtet, durch eine Person 115 berührt zu werden. Die Schutzschicht 305 kann beispielsweise aus Acryl oder Glas hergestellt sein. Der Dunkelfilter 310 kann einen Durchtritt von Licht in vorbestimmten Abschnitten blockieren. Insbesondere kann der Dunkelfilter 310 den Durchtritt von Licht nur im Bereich eines Bedienelements 110 und nicht zwischen zwei benachbarten Bedienelementen 110 erlauben. Der Farbfilter 315 kann eine ein- oder mehrfarbige Maske realisieren, die einem durchtretenden Lichtstrom ein vorbestimmtes Muster aufprägt. Für einen Betrachter kann das Muster beispielsweise ein Symbol oder eine Darstellung ergeben.

Die Diffusionsschicht 320 ist dazu eingerichtet, einen durchtretenden Lichtstrom möglichst homogen zu machen. Eine Leuchtdichte des Lichtstroms über die Fläche der Scheibe 120 im betreffenden Abschnitt des Bedienelements 110 kann dadurch gleichmäßig sein. Die Elektrodenschicht 325 kann die Elektrode 170 tragen. Dazu kann die Elektrodenschicht 325 beispielsweise ein transparentes, aber elektrisch leitfähiges Material umfassen, eine Bedampfung mit einem leitfähigen Material wie Metall tragen oder dünne leitfähige Strukturen umfassen.

Die Klebeschicht 330 ist dazu eingerichtet, zwei angrenzende Schichten stoffschlüssig miteinander zu verbinden. Die Abblendschicht 335 kann dazu genutzt werden, schräg in die Scheibe 120 einfallendes Licht zu blockieren. Die Lichtführungsschicht 340 kann eine Art Rahmen darstellen, der Licht nur in vorbestimmten Abschnitten durchlässt.

Es ist weiterhin zu beachten, dass einzelne Schichten 305 bis 340 auf eine obere oder untere Oberfläche einer Folie oder eines Films aufgebracht werden können. So können aneinander angrenzende Schichten 305 bis 340 miteinander integriert sein. Beispielsweise kann der Farbfilter 315 auf die Diffusionsschicht 320 aufgedruckt sein.

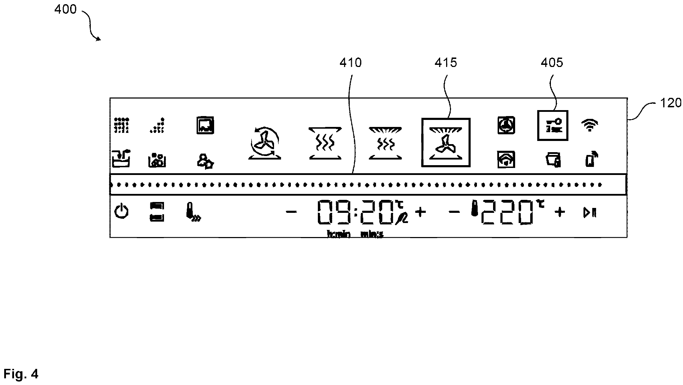

Figur 4 zeigt eine beispielhafte Bedienoberfläche 400 eines Haushaltsgeräts 100. Gezeigt ist eine Ansicht auf eine beispielhafte Scheibe 120 einer Steuereinrichtung 105 eines Haushaltsgeräts 100. Die Darstellung ist einem Betrachter zugewandt und kann sich einer Person 115, welche das Haushaltsgerät 100 bedient, so darstellen. Beispielhaft ist als Haushaltsgerät 100 ein Backofen vorausgesetzt. Andere Haushaltsgeräte, beispielsweise ein Kochfeld, ein Kaffeeautomat, ein Geschirrspüler, ein Bügeleisen, eine Waschmaschine oder ein Wäschetrockner, können ebenfalls umfasst sein.

Ein beispielhaftes erstes Bedienelement 405 ist dazu eingerichtet, eine Kindersicherung der Steuereinrichtung 105 zu deaktivieren. Dazu ist das erste Bedienelement 405 dazu eingerichtet, eine Betätigungskraft zu bestimmen. Genauer gesagt ist das erste Bedienelement 405 bevorzugt dazu eingerichtet, zu bestimmen, dass eine ausgeübte Betätigungskraft über eine vorbestimmte Dauer einen vorbestimmten Wert überschreitet. Dieser Wert kann so hoch gewählt sein, dass eine entsprechende Betätigungskraft durch ein Kleinkind üblicherweise nicht aufgebracht werden kann.

Ein zweites beispielhaftes Bedienelement 410 ist dazu eingerichtet, einen analogen Wert einzugeben, beispielsweise eine gewünschte Ofentemperatur. Das zweite Bedienelement 410 wird lediglich kapazitiv abgetastet und erlaubt es, einen Ort auf der Scheibe 120 zu bestimmen, an dem sich ein Körperteil der Person 115, beispielsweise eine Fingerspitze, befindet. Der analoge Wert kann eingestellt werden, indem die Person 115 diesen Ort nach rechts oder links variiert.

Ein drittes beispielhaftes Bedienelement 415 ist dazu eingerichtet, einen Umluftbetrieb des Haushaltsgeräts 100 zu steuern. Dazu kann das dritte Bedienelement 415 sowohl eine kapazitive Bestimmung als auch eine Kraftbestimmung unterstützen. Berührt die Person 115 das dritte Bedienelement 415 nur kurz, so kann ein Lüfter des Backofens 100 ein- bzw. ausgeschaltet werden. Drückt die Person 115 das dritte Bedienelement 415 mit einer gewissen Betätigungskraft, so kann eine Drehzahl des Lüfters in Abhängigkeit der Betätigungskraft eingestellt werden.

Es ist zu beachten, dass die genannten Beispiele lediglich zur Erläuterung einer hierin vorgeschlagenen Technik für ein verbessertes Bedienelement aufzufassen sind. Unterschiedliche Haushaltsgeräte 100 können unterschiedliche Bedienelemente 110 umfassen, die jeweils angepasste Funktionen des Haushaltsgeräts 100 steuern können.

### Bezugszeichen

- 100: Haushaltsgerät
- 105: Steuereinrichtung
- 110: Bedienelement
- 115: Person

- 120: Scheibe
- 125: Leiterplatte
- 130: Lichtquelle
- 135: Lichtsensor

- 140: erster Teil des Lichtstroms, durch die Scheibe
- 145: zweiter Teil des Lichtstroms, an der Scheibe reflektiert
- 150: Stützelement

- 155: Treiber
- 160: Messverstärker
- 165: Verarbeitungseinrichtung
- 170: Elektrode
- 175: Aktuator
- 180: Schnittstelle

- 200: Zusammenhang
- 205: vorbestimmter Abstand
- l: Lichtstrom
- h: Abstand

- 305: Schutzschicht
- 310: Dunkelfilter
- 315: Farbfilter
- 320: Diffusionsschicht
- 325: Elektrodenschicht

- 330: Klebeschicht
- 335: Abblendschicht
- 340: Lichtführungsschicht

- 400: Bedienoberfläche
- 405: erstes Bedienelement, mit Kraftbestimmung
- 410: zweites Bedienelement, mit kapazitiver Bestimmung
- 415: drittes Bedienelement, mit kapazitiver Bestimmung und Kraftbestimmung

## Patentansprüche

1. Bedienelement (110) für ein Haushaltsgerät (100), wobei das Bedienelement (110) folgende Elemente umfasst:
- eine Lichtquelle (130) und einen Lichtsensor (135);
- eine transparente Scheibe (120) zur Abdeckung der Lichtquelle (130) und des Lichtsensors (135);
- wobei die Scheibe (120) in Abhängigkeit einer auf sie wirkenden Betätigungskraft elastisch verformbar ist;
- wobei die Scheibe (120), die Lichtquelle (130) und der Lichtsensor (135) derart zueinander angebracht sind, dass ein erster Teil (140) eines durch die Lichtquelle (130) bereitgestellten Lichtstroms durch die Scheibe (120) fällt und ein zweiter Teil (145) des Lichtstroms an der Scheibe (120) in Richtung des Lichtsensors (135) reflektiert wird; und
- eine Verarbeitungseinrichtung (165) zur Bestimmung der Betätigungskraft auf der Basis eines vom Lichtsensor (135) erfassten Lichtstroms.

2. Bedienelement (110) nach Anspruch 1, wobei die Verarbeitungseinrichtung (165) dazu eingerichtet ist, eine vorbestimmte Funktion des Haushaltsgeräts (100) in Abhängigkeit der bestimmten Betätigungskraft zu steuern.

3. Bedienelement (110) nach Anspruch 2, wobei die Verarbeitungseinrichtung (165) dazu eingerichtet ist, zu bestimmen, dass die Betätigungskraft einen vorbestimmten Schwellenwert übersteigt; und ein weiteres Bedienelement (110) in Abhängigkeit der Betätigung zu aktivieren.

4. Bedienelement (110) nach einem der vorangehenden Ansprüche, wobei die Scheibe (120) eine Maske umfasst, um dem ersten Lichtstrom ein vorbestimmtes Muster aufzuprägen.

5. Bedienelement (110) nach Anspruch 4, wobei die Scheibe (120) mehrere Schichten (305-340) umfasst, und eine der Schichten (315) die Maske trägt.

6. Bedienelement (110) nach einem der Ansprüche 4 oder 5, wobei ein opaker Abschnitt der Maske dazu eingerichtet ist, einen von der Lichtquelle (130) aus einstrahlenden Lichtstrom zu reflektieren.

7. Bedienelement (110) nach einem der vorangehenden Ansprüche, wobei an der Scheibe (120) ein Reflexelement angebracht ist, um einen Teil (145) des von der Lichtquelle (130) einfallenden Lichtstroms zu reflektieren.

8. Bedienelement (110) nach einem der vorangehenden Ansprüche, wobei die Scheibe (120) eine Elektrode (170) umfasst; und die Verarbeitungseinrichtung (165) dazu eingerichtet ist, eine Berührung der Scheibe (120) auf der Basis einer Änderung der Kapazität der Elektrode zu bestimmen.

9. Bedienelement (110) nach Anspruch 8, wobei ein Ort, an der die Scheibe (120) berührt wird, mittels der Elektrode (170) und eine Kraft, mit der die Scheibe (120) an der Stelle betätigt wird, mittels der Lichtquelle (130) und dem Lichtsensor (135) bestimmt wird.

10. Bedienelement (110) nach einem der vorangehenden Ansprüchen, ferner umfassend ein Stützelement (150), um eine Verformung der Scheibe (120) auf einen Abschnitt zu begrenzen, in welchem die Lichtquelle (130) und der Lichtsensor (135) angeordnet sind.

11. Bedienelement (110) nach einem der vorangehenden Ansprüche, wobei die Scheibe (120) mehrere Abschnitte umfasst; und den Abschnitten voneinander unabhängige Einrichtungen zur Erfassung einer Betätigung und/oder Berührung eines Abschnitts zugeordnet sind.

12. Bedienelement (110) nach einem der vorangehenden Ansprüche, ferner umfassend einen Aktuator (175), der mit der Scheibe (120) verbunden ist; wobei die Verarbeitungseinrichtung (165) dazu eingerichtet ist, den Aktuator in Abhängigkeit einer erfassten Betätigung anzusteuern.

13. Steuereinrichtung (105) für ein Haushaltsgerät (100); wobei die Steuereinrichtung (105) ein Bedienelement (110) nach einem der vorangehenden Ansprüche umfasst.

14. Haushaltsgerät (100), umfassend ein Bedienelement (110) nach einem der Ansprüche 1 bis 12 und/oder eine Steuereinrichtung nach Anspruch 13.
